# EUROPÄISCHE PATENTSCHRIFT

(11) **EP 0 642 697 B1**
(45) Veröffentlichungstag und Bekanntmachung des Hinweises auf die Patenterteilung: **03.06.1998**
(21) Anmeldenummer: 94911956.4
(22) Anmeldetag: 25.03.1994
(51) Int. Cl.: H01L 21/00

(54) **EINRICHTUNG ZUM HANDELN VON SCHEIBENFÖRMIGEN OBJEKTEN IN EINER HANDLINGEBENE EINES LOKALEN REINRAUMES**
DEVICE FOR HANDLING WAFER-SHAPED OBJECTS IN A HANDLING PLANE OF A LOCAL CLEAN ROOM
DISPOSITIF PERMETTANT DE MANIPULER DES OBJETS SE PRESENTANT SOUS FORME DE TRANCHES DANS LE PLAN DE MANIPULATION D'UNE SALLE BLANCHE LOCALE

(30) Priorität: 29.03.1993 DE 4310149
(43) Veröffentlichungstag der Anmeldung: 15.03.1995
(73) Patentinhaber: JENOPTIK Aktiengesellschaft, 07739 Jena (DE)
(72) Erfinder: LAHNE, Berndt, D-07747 Jena (DE); SCHULTZ, Klaus, D-07745 Jena (DE); SCHELER, Werner, D-07743 Jena (DE); HEITMANN, Michael, D-07747 Jena (DE); GAGLIN, Axel, D-07747 Jena (DE)
(74) Vertreter: Geyer, Werner, Dr.-Ing.
(86) Internationale Anmeldenummer: EP9400959
(87) Internationale Veröffentlichungsnummer: WO9423443

(56) Entgegenhaltungen:
- EP-A- 0 238 751
- US-A- 4 746 256
- US-A- 4 895 486
- SOLID STATE TECHNOLOGY, Bd.33, Nr.8, August 1990, WASHINGTON US Seiten S1 - S5 CLAUDE DOCHE 'WAFER CONFINEMENT FOR CONTROL OF CONTAMINATION IN MICROELECTRONICS'
- SOLID STATE TECHNOLOGY, Bd.29, Nr.12, Dezember 1986, WASHINGTON US Seiten 61 - 65 HIROSHI HARADA 'SMIF SYSTEM PERFORMANCE AT 0.22 MICROMETER PARTICLE SIZE'
- EXTENDED ABSTRACTS, Bd.88, Nr.2, 1988, PRINCETON, NEW JERSEY US Seiten 599 - 600 'A SMIF-VACUUM INTERFACE CHAMBER'

## Beschreibung

Die Erfindung betrifft eine Einrichtung zum Handeln von scheibenförmigen Objekten in einer Handlingebene eines lokalen Reinraumes, der eine gegenüber der Handlingebene meßbar in der Höhe verstellbaren Magazinaufnahme und im wesentlichen in der Handlingebene liegende Arbeitsstationen für Bearbeitungs- und Inspektionszwecke enthält. Derartige technische Lösungen sind bei der Herstellung integrierter Schaltkreise, insbesondere für Handlingaufgaben anwendbar.

Steigender Integrationsgrad und sinkende Strukturbreiten führen bei der Herstellung integrierter Schaltkreise zu immer höheren Anforderungen an die Reinraumqualität. Zur Gewährleistung der Reinraumanforderungen werden für den Transport von scheibenförmigen Objekten (Wafer oder Masken) zu einzelnen Bearbeitungsmaschinen in zunehmendem Maße standardisierte Transportbehälter, sogenannte Standard Mechanical Inter Face Boxen (SMIF-Boxen) verwendet, auf deren Boden das Magazin, in dessen Fächern sich die Objekte befinden, in geeigneter Weise fixiert ist. Zur Beschickung der Bearbeitungsmaschinen werden die Magazine aus den Transportbehältern mit geeigneten Mitteln entladen und die Objekte mit einem Handler entnommen. Nach der Bearbeitung erfolgt sowohl deren Rückführung in die Fächer des Magazins als auch die des Magazins in den Transportbehälter.
Eine Verwendung war bisher im wesentlichen nur auf Großgeräte wie Waferstepper, Implanter u.a. beschränkt, so daß eine durchgängige Anwendbarkeit derartiger SMIF-Lösungen für eine Vielzahl von Prozeßschritten derzeit noch nicht gegeben ist. Die Magazine werden mit den Objekten oft durch mehr oder weniger komplexe Geräte aus den SMIF-Boxen entnommen und manuell oder automatisch auf die Bearbeitungs- und Inspektionsgeräte umgesetzt.

Mit der Schaffung von lokalen Reinräumen, die sich auf ein Gerät beziehen, nach außen abgeschlossen sind und eine definierte Ein-/Ausgabeschnittstelle aufweisen, können Anforderungen an den umgebenden Reinraum herabgesetzt werden, oder es sind in herkömmlichen Reinräumen bessere Reinraumklassen in der Umgebung der Objekte zu erzielen.

In der US-Patentschrift 4 746 256 wird eine Einrichtung zum Handeln und zur Inspektion von Wafern oder Masken als scheibenförmige Objekte in einem lokalen Reinraum mit SMIF-Box, Handler und Arbeitsstation beschrieben. Handler und Arbeitsstation sind von einer nach außen abschließenden Hülle umgeben, in die das Magazin mit den Objekten nach Aufsetzen der SMIF-Box auf die Hülle einführbar und auf einer Aufnahme abstellbar ist.
Der Handler ist zur Entnahme der Objekte aus verschiedenen Ebenen des Magazins und zur Übergabe an die Arbeitsstation in der z-Achse verstellbar.

EP-A-0 238 751 offenbart einen lokalen Reinraum, bei dem sich eine Luftaufbereitungsanlage oberhalb des Gehäuses befindet. Dieses Dokument entspricht dem Oberbegriff des Anspruchs 1.

Außerdem ist es gemäß der US-Patentschrift 4 895 486 bekannt, mit einem Kontrollgerät die Anwesenheit waferartiger Objekte in einem Träger (Magazin) und deren relative Lage zu einer Bezugsebene in dem Magazin zu bestimmen, indem ein erstes Signal für die Anwesenheit eines derartigen Objektes und ein Ortssignal für das Objekt miteinander verknüpft werden.
Das erste Signal wird durch einen optoelektronischen Sensor gewonnen, der den Raum, in dem sich die Objekte befinden können, überwacht. Das zweite Signal entsteht über einen mit einem Antrieb zum Auf- und Abfahren des Magazins gekoppelten Positionsencoder.
Zur Bestimmung der Bezugsebene und des möglichen Aufenthaltsraumes der Objekte wird der Raum im Magazin vertikal in Segmente aufgeteilt. Neben einem als Bezugsebene dienenden Segment und Segmenten ohne waferartige Objekte, werden Window-Segmente definiert, in denen Objekte vorhanden sein können.
Es erfolgt eine Indexierung des Magazins, indem nach einer meßtechnischen Erfassung der Bezugsebene in dem Magazin die Orte der Window-Segmente rechnerisch über die Konstruktionsdaten des jeweils verwendeten Magazins ermittelt und gespeichert werden.

Mit der zuletzt beschriebenen Lösung kann zwar die Anzahl der Objekte und deren Ablageorte relativ zu einer Bezugsebene innerhalb des Magazins bestimmt werden. Jedoch ist zur Entnahme der Objekte aus dem Magazin dieses oder der Handler im Rastermaß der Fächer des Magazins zu positionieren. Voneinander abweichende Magazingeometrien und Toleranzen müssen dabei berücksichtigt werden oder Fehler sind nicht auszuschließen. Probleme treten dann auf, wenn ein leeres Magazin beliebig beschickt werden soll oder Umsortierungen innerhalb eines Magazins oder von Magazin zu Magazin als vorbereitende oder nachgeordnete Prozesse zur Bearbeitung oder Inspektion erforderlich sind.

Aufgabe der Erfindung ist es, derartige, der Bearbeitung und Inspektion der scheibenförmigen Objekte vorangestellte oder nachgeordnete Prozeßschritte unter den Bedingungen eines lokalen Reinraumes sowohl beim Einsatz von SMIF-Boxen als auch beim zumindest teilweisen Verzicht auf diese Boxen zu gewährleisten.

Die Aufgabe wird erfindungsgemäß durch eine Einrichtung zum Handeln von scheibenförmigen Objekten in einer Handlingebene eines lokalen Reinraumes, wie in Anspruch 1 offenbart, gelöst.

Der von einer Luftaufbereitungsanlage erzeugte Luftstrom ist auf eine zur Luftaufbereitungsanlage gegenüberliegende, den Reinraum nach außen begrenzende Wand gerichtet, die Luftaustrittsöffnungen aufweist, deren Gesamtquerschnitt oberhalb des Zwischenbodens kleiner als der Gesamtquerschnitt unterhalb des Zwischenbodens ist.

Unterhalb des Zwischenbodens durch Antriebselemente entstehende Partikel, die die Reinraumverhältnisse störend beeinflussen könnten, werden am Eindringen in den Handling-, Bearbeitungs- und Inspektionsraum gehindert.

Vorteilhafterweise sind in der Luftaufbereitungsanlage, die in einem gemeinsamen, als Plenum dienenden Gehäuse zwischen einer Einlaß- und einer Auslaßöffnung in Strömungsrichtung nacheinander angeordnet, einen Axiallüfter und ein Filter enthält, die Einlaßöffnung und der Axiallüfter durch eine rohrförmige Ummantelung vom Plenum bis auf einen Luftaustritt in Strömungsrichtung getrennt. Der Luftaustritt enthält in den Luftstrom gestellte, rotatorischen Luftstromkomponenten entgegenwirkende Luftleitflächen.

Von Vorteil ist es, wenn der Luftaustritt aus symmetrisch zur Rotationsachse des Axiallüfters in eine mit der Ummantelung verbundenen Platte eingearbeiteten, kreissektorförmigen Ausschnitten besteht, in die die Luftleitflächen parallel gerichtet zu den Lüfterschaufeln des Axiallüfters gestellt sind.

Die Einrichtung zur Indexierung weist einen aus Sender und Empfänger bestehenden optoelektronischen Sensor auf, durch den eine meßtechnische Erfassung sowohl der Magazinfächer als auch der scheibenförmigen Objekte in ihrer Lage relativ zu der Bezugsebene erfolgt.

Ein von dem Sender ausgehendes, mit seinem Mittenstrahl in der Bezugsebene liegendes Meßstrahlenbündel ist zwischen gegenüberliegenden, die Magazinfächer enthaltenden Wänden hindurchgeführt und auf das Meßstrahlenbündel abschattende, in das Innere des Magazins weisende, fächerbildende Vorsprünge einer der Wände gerichtet, die als Auflage für die scheibenförmigen Objekte dienen. Durch die Höhenverstellung in Richtung der übereinanderliegenden Magazinfächer, die dadurch aufeinanderfolgend eine gemeinsame Lage mit der Bezugsebene einnehmen, erfolgt eine Erzeugung eines Abbildes sowohl der Magazinfächer als auch der in den Magazinfächern befindlichen scheibenförmigen Objekte durch eine Modulation des Meßstrahlenbündels.

Mit einem einzigen Sensorsystem werden die Magazinfächer selbst und darin enthaltene Objekte meßtechnisch erfaßt, wodurch die tatsächlich gegebenen Verhältnisse ermittelt werden, im Gegensatz zu einer rechentechnischen Bestimmung der Lage eines Magazinfaches aus den Konstruktionsdaten oder der Bestimmung der Lage anhand eines Indexermaßstabes. Dadurch sind Entnahme und Rückführung beliebig ausführbar, wodurch Umsortierungen in jeder Art und Weise, auch zwischen Magazinen mit unterschiedlichem Fächerabstand sowohl untereinander als auch zu einer Bezugsebene innerhalb des Magazins möglich werden. Auch leere Magazine können beliebig gefüllt werden.

Zur Positionierung aus dem Magazin herausragender scheibenförmiger Objekte ist eine Waferrückführeinrichtung vorgesehen, deren Wirksamwerden an ein Sensorsignal eines zweiten Sensors gebunden ist, dessen Meßstrahlenbündel parallel zu den scheibenförmigen Objekten gerichtet und bei der Höhenverstellung des Magazins dessen zur Entnahme und Beschickung dienenden Seite unmittelbar benachbart ist.

Die Waferrückführeinrichtung führt, ausgelöst durch das Sensorsignal, das Objekt ohne äußere Eingriffe in das Magazinfach zurück. Ohne einen manuellen Eingriff wird ein Weitertransport des Magazins in den Transportbehälter gewährleistet und eine Beschädigung herausragender Objekte vermieden.

Zum Handeln dient ein Handler mit einem mehrgliedrigen Gelenkarm, dessen Drehachsen Hohlachsen sind, und dessen vorderes Glied zur Aufnahme des scheibenförmigen Objektes eine Unterdruckhaltevorrichtung besitzt, von der aus eine direkte Verbindung zu einem in den Hohlachsen vorhandenen Vakuum besteht.

Die Erfindung soll nachstehend anhand der schematischen Zeichnung näher erläutert werden. Es zeigen:
- Fig. 1: eine Vorderansicht einer Einrichtung zum Handeln scheibenförmiger Objekte
- Fig. 2: eine Draufsicht auf den Zwischenboden in der Einrichtung gemäß Fig. 1
- Fig. 3: eine Luftaufbereitungsanlage
- Fig. 4: in perspektivischer Darstellung eine Anordnungsmöglichkeit für die Luftleitbleche
- Fig. 5: teilweise im Schnitt eine Einrichtung zur Indexierung
- Fig. 6: die Anordung eines optoelektronischen Sensors in Verbindung mit einer Schnittdarstellung durch das Magazin
- Fig. 7: die Vorderansicht eines Magazins mit Querschnittsdarstellung eines Meßstrahlenbündels
- Fig. 8: in benachbarter Darstellung einen Ausschnitt aus einem der Wände des Magazins mit eingeschobenen scheibenförmigen Objekten und ein mittels des optoelektronischen Sensors abgetastetes Bild des Ausschnittes
- Fig. 9: eine Draufsicht auf das Magazin mit einem zweiten Sensor und einer Waferrückführeinrichtung
- Fig. 10: in einem Blockschaltbild die Verknüpfung von Steuer-, Verarbeitungs- und Auswerteeinheiten mit übrigen Einheiten zur Ausführung der Indexierung
- Fig. 11: einen Handler in Seitenansicht

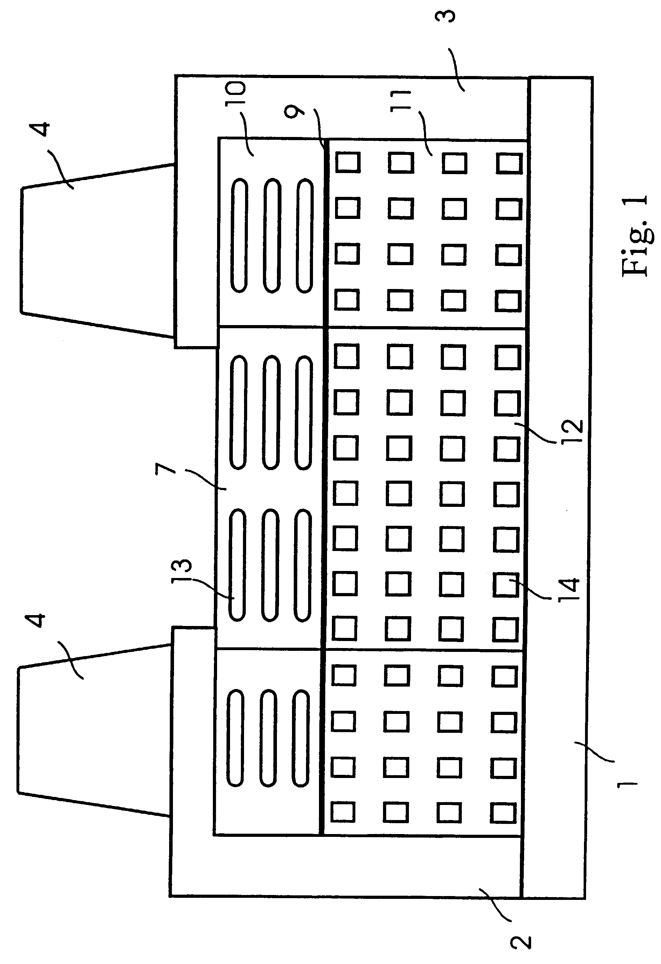

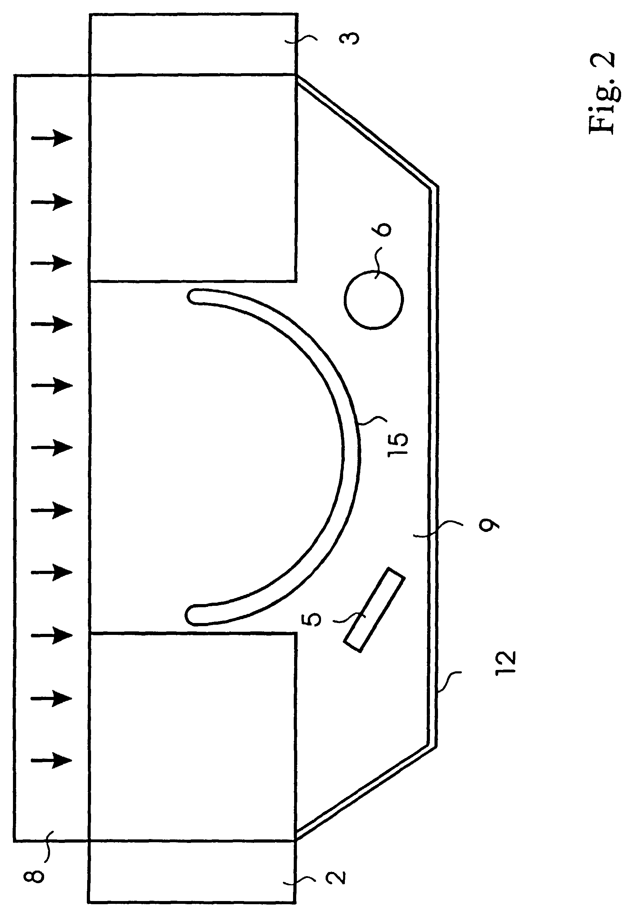

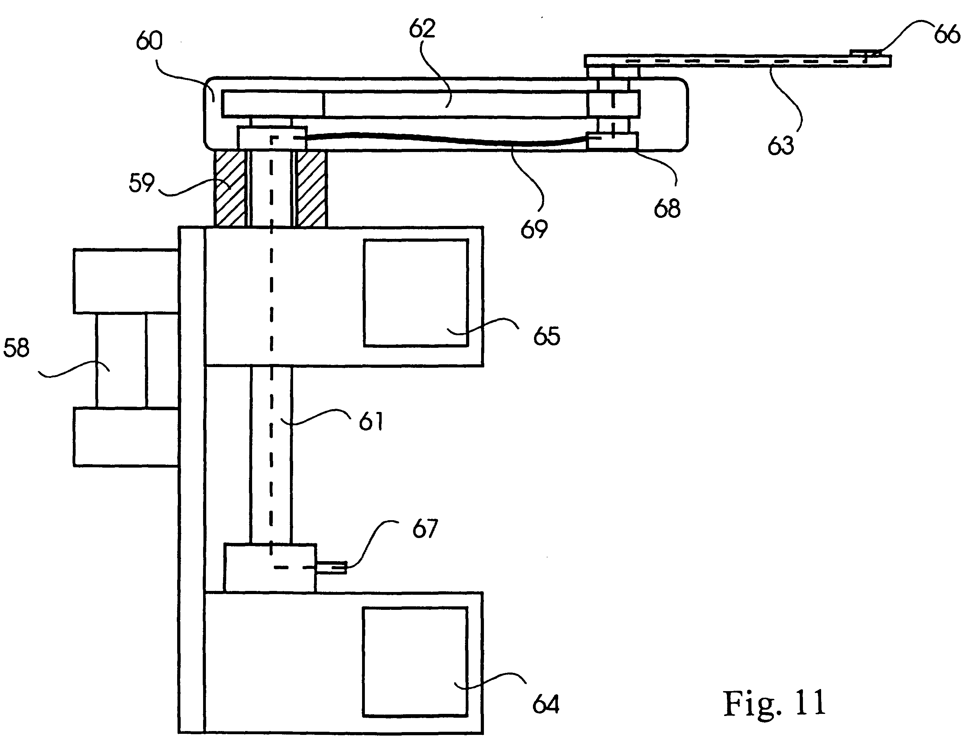

Gemäß den Figuren 1 und 2 bilden zwei sich gegenüberliegende, auf einem Träger 1 montierte Einrichtungen 2, 3 zur Indexierung von Magazinen für scheibenförmige Objekte zusammen mit einem, in dieser Figur verdeckten Handler, der in Fig. 11 näher beschrieben ist, und Arbeitsstationen 5, 6, wie z.B. ein Prealiner und ein Wobbeltisch eine Grundausrüstung gemäß der Erfindung, die von einem Enclosure 7 umschlossen ist. Aufgesetzte SMIF-Boxen sind mit 4 bezeichnet. Eine Luftaufbereitungsanlage 8 sorgt für einen laminaren Luftstrom der geforderten Reinheit.
Weitere Arbeitstationen können ein Barcodeleser oder ein OCR-Leser sein. Funktionell ist die Einrichtung geeignet als visuelle Inspektionseinrichtung, Flat- oder Notchfinder, Batchtransfereinrichtung, Loader oder Unloader, Merger und als Splitter zu dienen.
Der Enclosure 7, der durch einen Zwischenboden 9 in zwei Teilräume 10, 11 geteilt ist, besitzt in seiner, der Luflaufbereintungsanlage 8 gegenüberliegenden, nach außen begrenzenden Wand 12 Ausbrüche 13, 14 zum Ausgleich des erzeugten Überdrucks.
Ein gegenüber dem Gesamtquerschnitt der Ausbrüche 14 kleinerer Gesamtquerschnitt der Ausbrüche 13 führt zu einer Luftstromkomponente, die vom Teilraum 10 oberhalb des Zwischenbodens 9 zum Teilraum 11 unterhalb des Zwischenbodens 9 gerichtet ist. Sowohl eine für den Handler vorgesehene Aussparung 15 als auch andere, nicht dargestellte Öffnungen im Zwischenboden 9, die für die Arbeitsstationen 5, 6 vorgesehen sind, gewährleisten ein Überströmen des Luftstromes, wodurch unterhalb des Zwischenbodens 9 durch Antriebselemente entstehende Partikel, die die Reinraumverhältnisse störend beeinflussen könnten, am Eindringen in den als Handling-, Bearbeitungs- und Inspektionsraum dienenden Teilraum 10 gehindert werden.

Ein Gehäuse 16 mit einer Einlaßöffnung 17 in einer Einlaßplatte 18 und einer Auslaßöffnung 19 in einer Auslaßplatte 20 enthält neben einem Axiallüfter 21 entlang einer Achse X - X angeordnet, die gleichzeitig Rotationsachse des Axiallüfters 21 ist, eine siebartige Ausgleichseinrichtung 22 und einen Hochleistungsschwebstoffilter 23, der mit den Seitenwänden des Gehäuses 16 dicht abschließt.

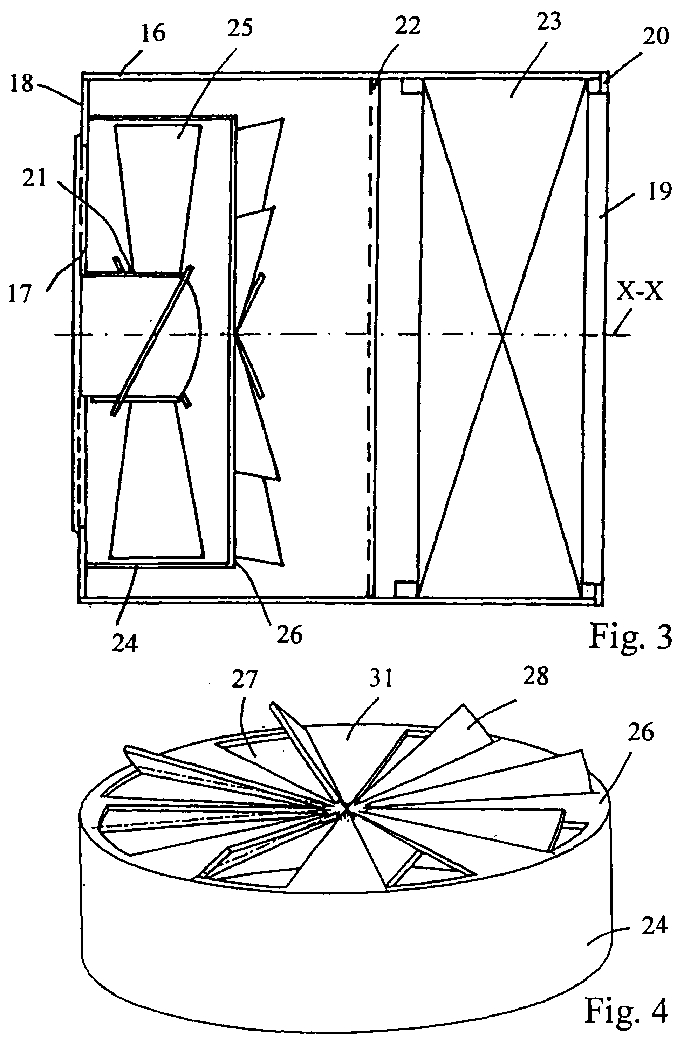

Eine mit einer Seite dicht an der Einlaßplatte 18 anliegende, als Rohrstutzen ausgebildete rohrförmige Ummantelung 24 trennt die Einlaßöffnung 17 und den Axiallüfter 21 bis auf einen Luftaustritt in Strömungsrichtung von Innenraum des Gehäuses 16, der gleichzeitig als Plenum dient. Der Rohrstutzen besitzt einen möglichst geringen Abstand zu den Lüfterschaufeln 25.
Der Luftaustritt besteht aus symmetrisch zur Rotationsachse in eine mit dem Rohrstutzen verbundenen Platte 26 eingearbeiteten, kreissektorförmigen Ausschnitten 27 mit Luftleitflächen in Form von Luftleitblechen 28, die in den vom Axiallüfter 21 erzeugten Luftstrom gestellt sind. Diese können diese sowohl in Richtung der Auslaßplatte 20, wie in Fig. 4 dargestellt, als auch in Richtung der Einlaßplatte 18 oder auch in beide Richtungen aus der Platte 26 herausragen.

Die Neigung der Luftleitbleche 28 gegen die Platte 26 richtet sich nach der Art und dem Aufbau des Axiallüfters 21. Im wesentlichen sollte eine parallele Ausrichtung zu den Lüfterschaufeln 25 gewählt werden.
Natürlich sind auch Luftleitbleche verwendbar, die sich infolge ihrer Größe paarweise überlappen. In diesem Fall kann auf die zum Hochleistungsschwebstoffilter 23 parallelen Flächenelemente 31 zwischen den Ausschnitten 27 verzichtet werden.
Der vom Axiallüfter 21 über die Einlaßöffnung 17 angesaugte und in Richtung der Auslaßöffnung 19 geblasene Luftstrom besitzt neben einer Richtungskomponente in Richtung der Auslaßöffnung 19 zwei Komponenten in Richtung der Seitenwände, so daß die Resultierende eine Drallbewegung des Luftstroms beschreibt. Diese Drallbewegung würde am Hochleistungsschwebstoffilter 23 eine ungleichmäßige Anströmung der Filterlamellen bewirken und so die wirksame Filterfläche nicht vorteilhaft ausnutzen, wodurch infolge erhöhten Luftwiderstands der Volumenstrom der erzeugten Reinluft sinkt.
Die in den Luftstrom der Drallbewegung entgegenwirkend gestellten Luftleitbleche 28 kompensieren die Komponenten in Richtung der Seitenwände, so daß der nunmehr zur Verfügung stehende Luftstrom nur noch die Komponente in Richtung der Auslaßöffnung 19 besitzt.
Durch die siebartige Ausgleichseinrichtung 22 wird der Anströmdruck vereinheitlicht. Die wirksame Fläche des Hochleistungsschwebstoffilters 23 wird senkrecht und gleichmäßig angeströmt.

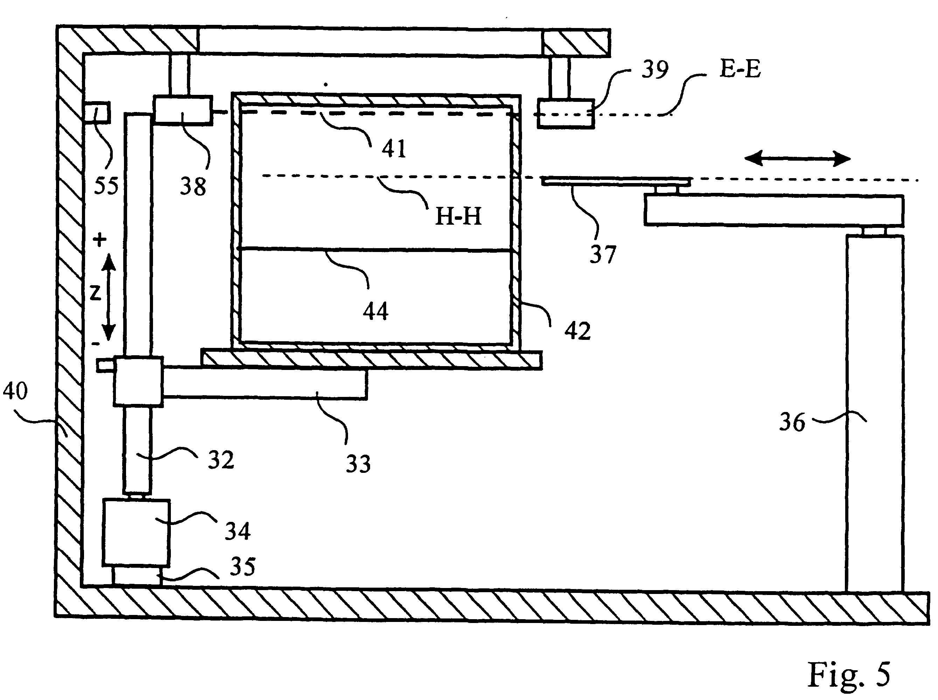

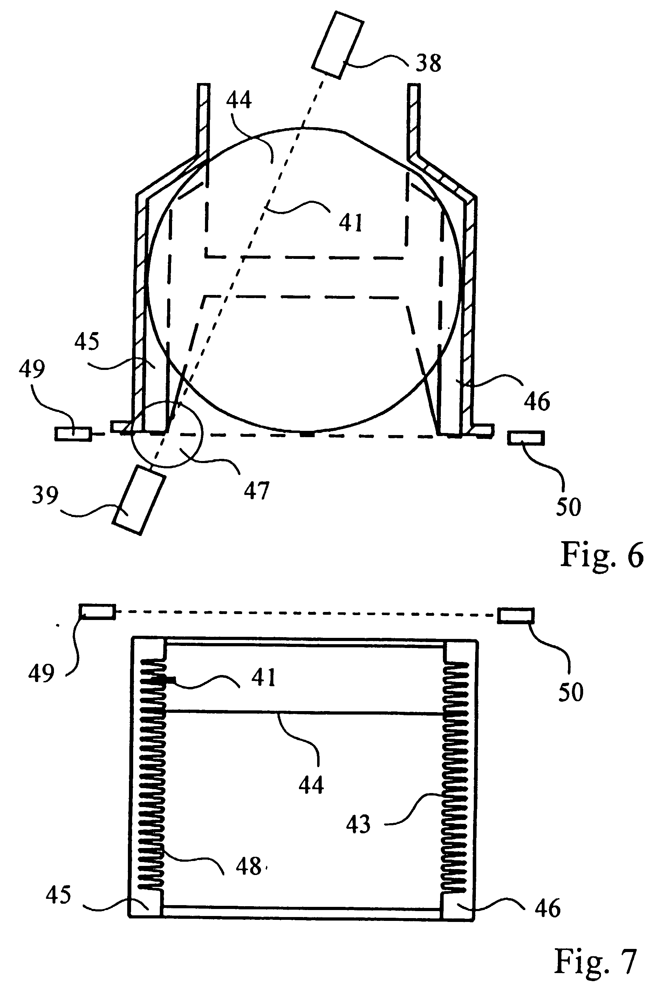

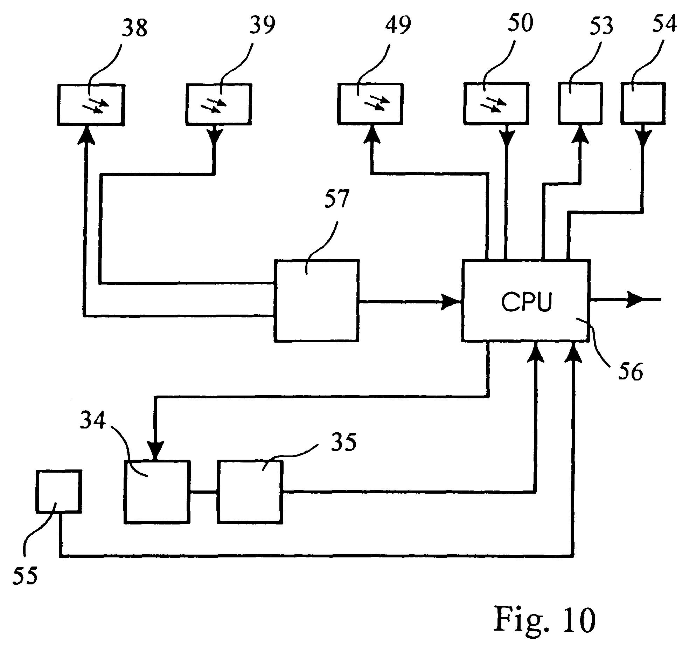

Eine Einrichtung zur Indexierung, von der in Fig. 5 lediglich ein Teil dargestellt ist, besitzt in ihrem Inneren eine über eine Spindel 32 in z-Richtung (senkrecht zur Aufstellfläche der Einrichtung) anheb- und absenkbare Magazinaufnahme 33. Der Antrieb der Spindel 32 erfolgt mit Hilfe eines Schrittmotors 34, der mit einem Winkelmeßsystem 35 ausgerüstet ist, so daß über die Spindelsteigung der zurückgelegte Weg beim Anheben oder Absenken ermittelt werden kann.
Der Schrittmotor 34 mit seiner Ansteuerelektronik und das Winkelmeßsystem 35 bilden gemeinsam mit einem Steuerrechner 56 gemäß Fig. 10 einen Positionsregler eines Magazinlifts, zu dem außerdem die Spindel 32 und die Magazinaufnahme 33 gehören. Ein Handler 36 besitzt einen in einer Handlingebene H-H arbeitenden Handlingarm 37 und ist wie der Magazinlift und ein optoelektronischer Sensor, der aus einem Sender 38 und einem Empfänger 39 besteht, an einem gemeinsamen Rahmen 40 befestigt. Ein von dem Sender 38 ausgehendes Meßstrahlenbündel 41 verläuft mit seinem Mittenstrahl in einer Bezugsebene E-E zur Indexierung von in einem Magazin 42 befindlichen, der Übersicht halber erst in Fig. 7 dargestellten Magazinfächern 43 und darin enthaltenen scheibenförmigen Objekten 44.
Der Abstand zwischen der Ebene E-E und der Handlingebene H-H ist innerhalb des Fahrbereiches des Spindelantriebes wählbar.

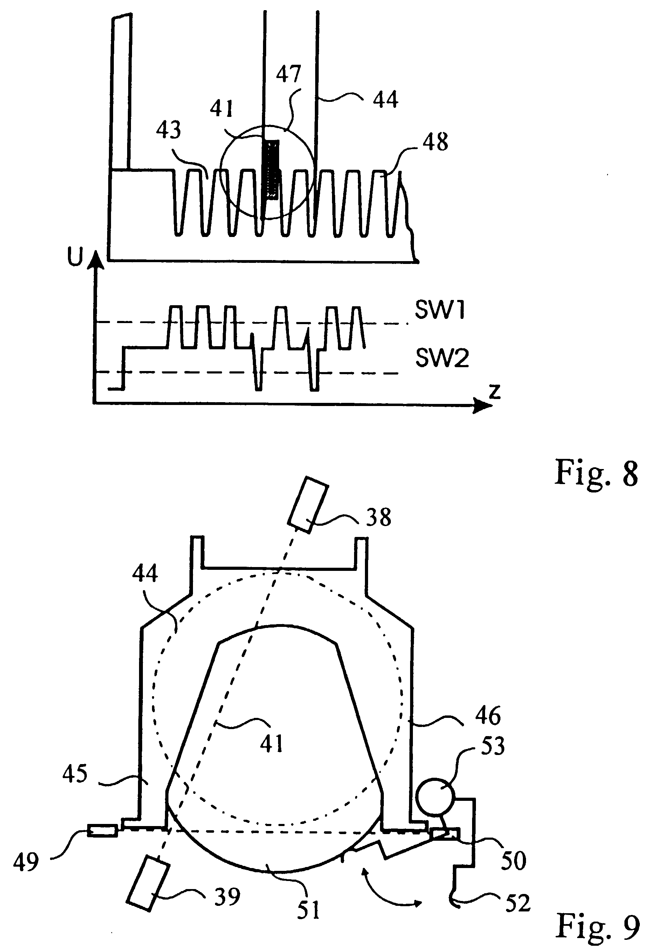

Die Figuren 6 und 7 verdeutlichen die Anordnung des Sensors in Bezug auf das Magazin 42 und in die Magazinfächer 43 möglicherweise eingeschobene scheibenförmige Objekte 44, wie z.B. Halbleitwscheiben oder Schablonen. Danach sind der Sender 38 und der Empfänger 39 so gelegt, daß das Meßstrahlenbündel 41 zwischen Wänden 45, 46 des Magazins 42 hindurchgeführt und auf einen Eckenabschnitt 47 gerichtet ist. Der Eckenabschnitt 47 reicht entsprechend Fig. 8 soweit in das Meßstrahlenbündel 41, daß in das Innere des Magazins 42 gerichtete Vorsprünge 48, die als Auflagen für die scheibenförmigen Objekte 44 dienen, das Meßstrahlenbündel 41 abschatten.
Die dargestellte schräge Durchstrahlung des Magazins 42 wurde gewählt, da dieses rückseitig meist teilweise verschlossen ist. Liegt ein derartiger Abschluß nicht vor, ist natürlich auch eine zu den Wänden 45 und 46 und den Magazinfächern 43 parallele Strahlenführung des Meßstrahlenbündels 41 möglich. Der Mittenstrahl des Meßstrahlenbündels 41 verläuft vorteilhafterweise direkt an der Vorderkante der Vorsprünge 48 entlang.
Neben dem ersten Sensor ist dem Magazin 42 auf dessen zur Entnahme und Beschikkung dienenden Seite ( dem Handler 36 zugewandte Seite) ein weiterer, aus einem Sender 49 und einem Empfänger 50 bestehender Sensor benachbart, der einen definierten Abstand zum ersten Sensor besitzt und aus dem Magazin 42 herausragende Objekte 51 beim Transport des Magazins 42 in positiver z-Richtung erkennt.
Wie in Fig. 9 dargestellt, ist zur Positionierung des aus dem Magazin 42 herausragenden Objektes 51, eine Waferrückführeinrichtung 52 vorgesehen, die in einer zur ersten Handlingebene H-H parallelen Ebene aufgrund der mit dem ersten Sensor gewonnenen Ortsinformation die Verschiebung des Objektes 51 in das Magazin 42 übernimmt. Damit kann der Transport des Magazins 42 ungestört ohne einen manuellen Eingriff fortgeführt werden.
Die Waferrückführeinrichtung 52 besteht aus einem elektromotorisch angetriebenen Hebelmechanismus 53, der bei einer Umdrehung seines Antriebs (nicht dargestellt) eine Schwenkbewegung von 90° ausführt. Der Umkehrpunkt des Hebels des Mechanismus 53 ist so angeordnet, daß er das Objekt 51 in das Magazin 42 schiebt und sich anschließend in eine Ausgangslage zurück begibt, die mit einem Endschalter 54 überwacht wird.

Gemäß Fig. 10 sind zur Ausführung der Erfindung der Schrittmotor 34, das Winkelmeßsystem 35, die Sender 38 und 49, die Empfänger 38 und 50, ein dritter, mit dem Rahmen 40 fest verbundener Sensor 55, der Hebelmechanismus 53 und der Endschalter 54 mit einem Steuerrechner 56 in der dargestellten Weise verknüpft. Zwischen den Sensoren und dem Steuerrechner 56 sind AD-Wandler vorgesehen, von denen ein AD-Wandler 57 in Fig. 10 eingezeichnet ist.

Nachdem die Magazinaufnahme 33 gegenüber dem dritten Sensor 55, der fest mit dem Rahmen 40 verbunden ist und einen bekannten Abstand zur Handlingebene H-H und zur Bezugsebene E-E besitzt, positioniert und der Zähler des Winkelmeßsystems genullt wurde, wird zur Indexierung der Magazinfächer 43 und der darin befindlichen scheibenförmigen Objekte 44 das Magazin 42 aus einem staubschützenden Transportbehälter (SMIF-Box) mit dessen Boden automatisch entnommen und von der Magazinaufnahme 33 übernommen. Danach wird die Magazinaufnahme 33 abgesenkt, also in negative z-Richtung gefahren, bis ein Schwellwert sw2 von vorteilhafterweise zur Datenreduzierung festgelegten Schwellwerten swl und sw2 überschritten wird. Damit ist vom Magazins 42 der Abstand seines Bodens zur Bezugsebene E-E erfaßt.
Bei der Bewegung des Magazins 42 in Richtung seiner übereinanderliegenden Magazinfächer 43 durch die Meßebene E-E erhält man ein die Magazinfächer 43 und die Objekte 44 als Abbild darstellendes amplitudenmoduliertes Sensorausgangssignal U als Funktion des Weges entsprechend Fig. 8 am Empfänger 39, das dem AD-Wandler 57 zugeführt und mit Hilfe des Steuerrechners 56 mit dem Meßsignal des Winkelmeßsystems 35 verknüpft und gespeichert wird.
Um ein Objekt 44 aus dem Magazin 42 zu entnehmen oder in ein leeres Magazinfach 43 zu plazieren, wird zu dem ermittelten Zählerstand ein Wert für den Abstand zwischen der Meßebene E-E und der ersten Handlingebene H-H addiert und das Magazin 42 mit Hilfe des Magazinlifts in die entsprechende z-Position gefahren.

Der in Fig. 11 dargestellte, durch einen Antrieb 58 zum Anheben der scheibenförmigen Objekte in z-Richtung geringfügig verstellbare Handler, der dem Handler 36 in Fig. 5 entspricht, ist als zweigliedriger Gelenkarm ausgebildet und besteht aus einem mit einer Hohlachse 59 verbundenen Oberarm 60 und einem Unterarm 63. Der Unterarm 63 ist über eine Achse 68, die durch einen Zahnriemen 62 mit einer Innenachse 61 in Verbindung steht, im Oberarm 60 gelagert. Die Achsen 59, 61 werden durch je einen Motor 64, 65, die vorzugsweise als Schrittmotore ausgebildet sind, angetrieben. Zur Erreichung der erforderlichen Positioniergenauigkeit sind die mit einem Winkelmeßsystem versehenen Motoren 64, 65 mit Hilfe hochuntersetzter Getriebe an die Achsen 59, 61 angekoppelt.
Eine am Unterarm 63 vorgesehene Unterdruckhaltevorrichtung 66 für die scheibenförmigen Objekte besitzt eine direkte Verbindung zu einem innerhalb der Achsen 61 und 68 geführten Vakuum. Eine Vakuumverbindung zwischen den Achsen 61 und 68 erfolgt über eine Vakuumleitung 69. Mit 67 ist eine, durch einen festen Anschluß realisierte Schnittstelle zu einer nicht dargestellten Vakuumpumpe bezeichnet. Die Vakuumzuführung über eine bewegte Leitung wird damit vermieden.

## Patentansprüche

1. Einrichtung zum Handeln von scheibenförmigen Objekten in einer Handlingebene eines lokalen Reinraumes, der durch einen mit Öffnungen zum Überströmen von Luft versehenen Zwischenboden (9) in zwei übereinanderliegende Teilräume (10, 11) unterteilt und von einem laminaren Luftstrom durchsetzt ist,
mit Luftaustrittsöffnungen in seiner nach außen begrenzenden Wand (12),
einer gegenüber der Handlingebene (H-H) meßbar in der Höhe verstellbaren Magazinaufnahme (33), mindestens einer Einrichtung zur Indexierung von Magazinfächern (43) eines Magazins (42) und darin enthaltenen scheibenförmigen Objekten (44) und im wesentlichen in der Handlingebene (H-H) liegenden Arbeitsstationen (5, 6) für Bearbeitungs- und Inspektionszwecke, dadurch gekennzeichnet, daß
der Teilraum (10) oberhalb des Zwischenbodens (9) die konstruktiv in fester Beziehung zu einer Bezugsebene (E-E) der Einrichtung zur Indexierung stehende Handlingebene (H-H) enthält, und daß
der laminare Luftstrom auf die nach außen begrenzende Wand (12) gerichtet ist, deren Luftaustrittsöffnungen (13) oberhalb des Zwischenbodens (9) einen kleineren Gesamtquerschnitt aufweisen als die Luftaustrittsöffnungen (14) unterhalb des Zwischenbodens (9),
wodurch eine aus dem Luftstrom erzeugte und aus dem Teilraum (10) oberhalb des Zwischenbodens (9) in den Teilraum (11) unterhalb des Zwischenbodens gerichtete Luftstromkomponente durch Antriebselemente im Teilraum (11) unterhalb des Zwischenbodens entstehende Partikel am Eindringen in den Teilraum (10) oberhalb des Zwischenbodens (9) hindert.

2. Einrichtung nach Anspruch 1, dadurch gekennzeichnet, daß in der Luftaufbereitungsanlage (8), die in einem gemeinsamen, als Plenum dienenden Gehäuse (16) zwischen einer Einlaßöffnung (17) und einer Auslaßöffnung (18) in Strömungsrichtung nacheinander angeordnet, einen Axiallüfter (21) und ein Filter (23) enthält, die Einlaßöffnung (17) und der Axiallüfter (21) durch eine rohrförmige Ummantelung (24) vom Plenum bis auf einen Luftaustritt in Strömungsrichtung getrennt sind, und daß der Luftaustritt in den Luftstrom gestellte, rotatorischen Luftstromkomponenten entgegenwirkende Luftleitflächen enthält.

3. Einrichtung nach Anspruch 2, dadurch gekennzeichnet, daß der Luftaustritt aus symmetrisch zur Rotationsachse (X-X) des Axiallüfters (21) in eine mit der Ummantelung (24) verbundenen Platte (26) eingearbeiteten, kreissektorförmigen Ausschnitten (27) besteht, in die die Luftleitflächen parallel gerichtet zu den Lüfterschaufeln (25) des Axiallüfters (21) gestellt sind.

4. Einrichtung nach Anspruch 1, dadurch gekennzeichnet, daß die Einrichtung zur Indexierung einen aus Sender (38) und Empfänger (39) bestehenden optoelektronischen Sensor aufweist, durch den eine meßtechnische Erfassung sowohl der Magazinfächer (43) als auch der scheibenförmigen Objekte (44) in ihrer Lage relativ zu der Bezugsebene (E-E) erfolgt.

5. Einrichtung nach Anspruch 4, dadurch gekennzeichnet, ein von dem Sender (38) ausgehendes, mit seinem Mittenstrahl in der Bezugsebene (E-E) liegendes Meßstrahlenbündel (41) zwischen gegenüberliegenden, die Magazinfächer (43) enthaltenden Wänden (45, 46) hindurchgeführt und auf das Meßstrahlenbündel (41) abschattende, in das Innere des Magazins (42) weisende, fächerbildende Vorsprünge (48) einer der Wände (45, 46) gerichtet ist, die als Auflage für die scheibenförmigen Objekte (44) dienen, und daß durch die Höhenverstellung in Richtung der übereinanderliegenden Magazinfächer (43), die dadurch aufeinanderfolgend eine gemeinsame Lage mit der Bezugsebene (E-E) einnehmen, eine Erzeugung eines Abbildes sowohl der Magazinfächer (43) als auch der in den Magazinfächern (43) befindlichen scheibenförmigen Objekte (44) durch eine Modulation des Meßstrahlenbündels (41) erfolgt.

6. Einrichtung nach einem der Ansprüche 1 bis 5, dadurch gekennzeichnet, daß zur Positionierung aus dem Magazin (42) herausragender scheibenförmiger Objekte (51) eine Waferrückführeinrichtung (52) vorgesehen ist, deren Wirksamwerden an ein Sensorsignal eines zweiten Sensors gebunden ist, dessen Meßstrahlenbündel parallel zu den scheibenförmigen Objekten (44, 51) gerichtet und bei der Höhenverstellung des Magazins (42) dessen zur Entnahme und Beschickung dienenden Seite unmittelbar benachbart ist.

7. Einrichtung nach Anspruch 6, dadurch gekennzeichnet, daß zum Handeln ein Handler mit einem mehrgliedrigen Gelenkarm dient, dessen Drehachsen Hohlachsen (59, 61, 68) sind, und dessen vorderes Glied zur Aufnahme des scheibenförmigen Objektes (44) eine Unterdruckhaltevorrichtung (66) besitzt, von der aus eine direkte Verbindung zu einem in den Hohlachsen (61, 68) vorhandenen Vakuum besteht.

## Claims

1. Apparatus for handling disc-shaped objects in a handling plane of a local clean room which is divided into two compartments (10, 11) lying one above the other by an intermediate base (9) provided with openings for air to flow over and which has a laminar air stream passing through it, with air outlet openings in its outer wall (12), a magazine receptacle (33) which is measurably adjustable in height relative to a handling plane (H-H), at least one device for indexing compartments (43) of a magazine (42) and disc-shaped objects (44) contained therein and work stations (5, 6) lying substantially in the handling plane (H-H) for processing and inspection purposes, characterised in that the compartment (10) above the intermediate base (9) contains the handling plane (H-H) which in structural terms is in a fixed relationship to a datum plane (E-E) of the indexing device, and that the laminar air stream is directed onto the outer wall (12), the air outlet openings (13) of which above the intermediate base (9) have a smaller total cross-section than the air outlet openings (14) below the intermediate base (9), as a result of which an air stream component produced from the air stream and directed out of the compartment (10) above the intermediate base (9) into the compartment (11) below the intermediate base prevents particles produced due to drive elements in the compartment (11) below the intermediate base from penetrating into the compartment (10) above the intermediate base (9).

2. Apparatus as claimed in Claim 1, characterised in that in the air preparation plant (8), which in a common housing (16) serving as plenum contains an axial fan (21) and a filter (23) disposed one after the other in the flow direction between an inlet opening (17) and an outlet opening (18), the inlet opening (17) and the axial fan (21) are separated from the plenum by a tubular casing (24) as far as an air outlet in the flow direction, and that the air outlet contains air baffles which are placed in the air stream and counteract rotating air stream components.

3. Apparatus as claimed in Claim 2, characterised in that the air outlet consists of cut-outs (27) in the shape of a sector of a circle which are provided symmetrically with respect to the axis of rotation (X-X) of the axial fan (21) by machining into a plate (26) connected to the casing (24), the air baffles being placed in these cut-outs so that they are directed parallel to the blades (25) of the axial fan (21).

4. Apparatus as claimed in Claim 1, characterised in that the indexing device has an optoelectronic sensor consisting of a transmitter (38) and a receiver (39) by means of which the position of the magazine compartments (43) and also of the disc-shaped objects (44) relative to the datum plane (E-E) is detected using measurement techniques.

5. Apparatus as claimed in Claim 4, characterised in that that a measurement beam (41) emanating from the transmitter (38) and lying with its central ray in the datum plane (E-E) is guided through between opposing walls (45, 46) containing the magazine compartments (43) and is directed onto projections (48) of one of the walls (45, 46) which projections shade the measurement beam (41), point into the interior of the magazine (42), form compartments and serve as support for the disc-shaped objects (44), and that an image of the magazine compartments (43) and also of the disc-shaped objects (44) located in the magazine compartments (43) is produced by a modulation of the measurement (41) due to the height adjustment in the direction of the magazine compartments (43) which lie one above the other and thereby one after the other assume a common position with the datum plane (E-E).

6. Apparatus as claimed in one of Claims 1 to 5, characterised in that for positioning of disc-shaped objects (51) projecting out of the magazine (42) a wafer return device (52) is provided, activation of which is associated with a sensor signal from a second sensor, the measurement beam of which is directed parallel to the disc-shaped objects (44, 51) and which during the height adjustment of the magazine (42) is immediately adjacent to the side thereof which serves for removal and supply.

7. Apparatus as claimed in Claim 6, characterised in that a handler with a multi-member articulated arm serves for handling, of which the axes of rotation are hollow shafts (59, 61, 68) and the front member has a vacuum holding device (66) to accommodate the disc-shaped object (44), and there is a direct connection from the vacuum holding device to a vacuum present in the hollow shafts (61, 68).

## Revendications

1. Dispositif de traitement d'objets discoïdes dans un plan de manipulation d'un local propre installé localement, subdivisé, par un fond intermédiaire (9) pourvu d'ouvertures destinées à laisser passer des écoulements d'air, en constituant deux enceintes partielles (10, 11) situées l'une au-dessus de l'autre et traversées par un courant d'air laminaire,
avec des ouverture de sortie d'air dans sa paroi (12) assurant la délimitation vis-à-vis de l'extérieur,
avec un logement de magasin (33), réglage en hauteur de façon mesurable par rapport au plan de manipulation (H-H), au moins un dispositif d'indexation de compartiments de magasin (43) appartenant à un magasin (42) et d'objets discoïdes (44) y étant contenus, et des postes de travail (5, 6) situés essentiellement dans le plan de manipulation (H-H), à des fins d'usinage et d'inspection,
caractérisé en ce que
l'enceinte partielle (10), située au-dessus du fond intermédiaire (9), contient le plan de manipulation (H-H) situé, par la construction, en relation fixe vis-à-vis d'un plan de référence (E-E) du dispositif, dans le but de l'indexation, et en ce que
l'écoulement d'air laminaire est dirigé sur la paroi (12) assurant la délimitation vers l'extérieur, dont les ouvertures de sortie d'air (13) ménagée au-dessus du fond intermédiaire (9) présentent une section transversale globale plus petite que celle des ouvertures de sortie d'air (14) se trouvant au-dessous du fond intermédiaire (9), faisant qu'une composante d'écoulement d'air, générée à partir de l'écoulement d'air et orientée à partir de l'enceinte partielle (10) prévue au-dessus du fond intermédiaire (9), pour passer dans l'enceinte partielle (11) prévue au-dessous du fond intermédiaire, empêche toute pénétration, dans l'enceinte partielle (10) se trouvant au-dessus du fond intermédiaire (9), de particules produites par des éléments d'entraînement dans l'enceinte partielle (11) se trouvant au-dessous du fond intermédiaire.

2. Dispositif selon la revendication 1, caractérisé en ce qu'un ventilateur axial (21) et un filtre (23) sont disposés l'un derrière l'autre dans la direction de l'écoulement, entre une ouverture d'admission (17) et une ouverture d'évacuation (18), dans l'installation de préparation d'air (8) contenant dans un carter (16) commun servant de plénum, l'ouverture d'admission (17) et le ventilateur axial (21) étant séparés vis-à-vis du plénum au moyen d'un enveloppement (24) tubulaire, jusqu'à la sortie d'air, et en ce que la sortie d'air contient des surfaces de guidage d'air calées dans l'écoulement d'air et agissant à l'encontre de la composante rotatoire de l'écoulement de l'air.

3. Dispositif selon la revendication 2, caractérisé en ce que la sortie d'air est constituée de découpures (27) en forme de secteurs de cercle, usinées dans une plaque (26) reliée à l'enveloppement (24), symétriquement par rapport à l'axe de rotation (X-X) du ventilateur axial (21), découpures dans lesquelles les surfaces de guidage d'air sont orientées parallèlement aux aubes de ventilateur (25) appartenant au ventilateur axial (21).

4. Dispositif selon la revendication 1, caractérisé en ce que le dispositif d'indexation présente un capteur optoélectronique constitué d'un émetteur (38) et d'un récepteur (39), capteur au moyen duquel est effectuée une détection, touchant une technique de mesure, tant des compartiments de magasin (43) qu'également des objets discoïdes (44), détection concernant leur position par rapport au plan de référence (E-E).

5. Dispositif selon la revendication 4, caractérisé en ce qu'un faisceau de rayons de mesure (41) partant de l'émetteur (48), ayant son rayon central dans le plan de référence (E-E), est passé entre des parois (45, 46) opposées contenant les compartiments de magasin (43), et est dirigé sur des saillies (48) formant des compartiments appartenant à l'une des parois (45, 46), saillies occultant le faisceau de rayons de mesure (41) et tournées vers l'intérieur du magasin (42), saillies servant de support pour les objets discoïdes (44), et en ce que, au moyen du réglage en hauteur pratiqué en direction des compartiments de magasin (43) situés les uns au-dessus des autres, prenant de ce fait les uns à la suite des autres une position commune avec le plan de référence (E-E), est effectué la génération d'une image, tant des compartiments de magasin (43) qu'également des objets discoïdes (44) se trouvant dans les compartiments de magasin (43), ceci au moyen d'une modulation du faisceau de rayons de mesure (41).

6. Dispositif selon l'une des revendications 1 à 5, caractérisé en ce que, pour assurer le positionnement d'objets discoïdes (51) ressortant du magasin (42), est prévu un dispositif de retour de galettes (52), dont la mise en action est liée à un signal de capteur venant d'un deuxième capteur, dont le faisceau de rayons de mesure est dirigé parallèlement aux objets discoïdes (44, 51) et capteur dont la face, servant au prélèvement et au garnissage, est placée au voisinage direct du magasin (52). lors du réglage en hauteur de celui-ci

7. Dispositif selon la revendication 6, caractérisé en ce que, pour assurer le traitement, est utilisé un manipulateur ayant un bras articulé à plusieurs membres dont les axes de rotation sont les axes creux (59, 61, 68) et dont le membre avant comporte, pour loger l'objet discoïde (54), un dispositif de maintien par vide (66), depuis lequel une liaison directe est établie vis-à-vis d'un vide régnant dans les axes creux (61, 68).
